# FASCICULE DE BREVET EUROPEEN

(11) **EP 2 064 742 B1**
(45) Date de publication et mention de la délivrance du brevet: **31.07.2019**
(21) Numéro de dépôt: 07820323.9
(22) Date de dépôt: 19.09.2007
(51) Int. Cl.: H01L 27/146

(54) **CAPTEUR D'IMAGE EN COULEUR A DIAPHOTIE AMÉLIORÉE**
FARBBILDSENSOR MIT VERBESSERTER OPTISCHER ÜBERLAPPUNG
COLOUR IMAGE SENSOR WITH IMPROVED OPTICAL CROSSTALK

(30) Priorité: 19.09.2006 FR 0608185
(43) Date de publication de la demande: 03.06.2009
(73) Titulaire: Teledyne e2v Semiconductors SAS, 38120 Saint-Egrève (FR)
(72) Inventeur: FEREYRE, Pierre, 38340 Voreppe (FR)
(74) Mandataire: Desvignes, Agnès
(86) Numéro de dépôt international: PCT/EP2007/059879
(87) Numéro de publication internationale: WO 2008/034838

(56) Documents cités:
- EP-A- 1 566 842
- EP-A- 1 653 520
- JP-A- 2005 150 521
- US-A- 5 172 206
- US-A1- 2004 079 865
- US-A1- 2005 218 417
- US-A1- 2006 081 898
- US-A1- 2006 145 219
- US-A1- 2006 169 878

## Description

L'invention concerne les capteurs d'image réalisés sur un substrat de silicium aminci. L'amincissement du silicium sur lequel est fait le capteur d'image est une technique permettant d'améliorer la diaphotie en minimisant les interférences entre points d'image voisins, notamment, pour les capteurs en couleurs, des points correspondant à des couleurs différentes. Les interférences sont réduites grâce au fait que l'éclairement se fait par la face arrière et non par la face avant d'une plaquette de silicium. La face avant est celle sur laquelle sont faites les opérations de dépôt et gravure de couches formant l'essentiel de la matrice de photodétecteurs et de ses circuits de commande. Lorsque des filtres de couleur sont déposés sur la face arrière, ils sont plus proches des zones photosensibles formées dans le silicium.

Un capteur d'image sur silicium aminci peut être réalisé de la manière suivante : on part d'une tranche semiconductrice (silicium en principe ou silicium sur isolant) sur la face avant de laquelle on effectue des opérations de masquage, d'implantations d'impuretés, de dépôts de couches de compositions diverses provisoires ou définitives, de gravure de ces couches, de traitement thermique, etc. ; ces opérations permettent de définir une matrice de pixels photosensibles et des circuits de traitement de signaux électriques associés à ces pixels ; on reporte ensuite la tranche par sa face avant contre la face avant d'un substrat de support ; on élimine la majeure partie de l'épaisseur de la tranche semiconductrice (c'est l'opération d'amincissement), laissant subsister sur la face avant du substrat de support une fine couche semiconductrice comprenant les zones photosensibles et les circuits associés ; et, ultérieurement, on dépose et on grave sur la face arrière de la couche semiconductrice ainsi amincie diverses couches parmi lesquelles par exemple une couche métallique opaque et une couche de filtres de couleur en mosaïque (pour les capteurs couleur).

On comprend qu'avec ce procédé l'arrivée de lumière ne se fait pas au travers d'un empilement de couches isolantes et conductrices qui ont pu être déposées (en technologie CMOS ou une autre technologie) sur les zones photosensibles au cours de la fabrication de la tranche semiconductrice. Bien au contraire, la lumière arrivera du côté de la face arrière du capteur, traversera les filtres colorés et atteindra directement les zones photosensibles sans avoir à traverser l'empilement de couches isolantes et conductrices.

L'épaisseur résiduelle de silicium après amincissement est de 3 à 20 micromètres environ.

Cependant, on constate dans la pratique qu'il subsiste des phénomènes de diaphotie (en anglais "cross-talk") entre pixels adjacents. La présente invention a pour but de réduire encore les défauts de diaphotie, notamment les défauts de colorimétrie dus à la diaphotie entre pixels adjacents. Ce problème est d'autant plus important que la surface des pixels est plus petite.

La diaphotie peut avoir des causes optiques (dispersion de photons vers des pixels adjacents comme cela a été expliqué ci-dessus) mais aussi des causes électroniques ; la diaphotie électronique provient de la dispersion d'électrons qui sont engendrés dans une zone photosensible correspondant à un pixel déterminé et qui devraient être collectés par une électrode correspondant à ce pixel mais qui sont en réalité attirés par une électrode d'un pixel voisin du fait de l'existence de champs électriques mal contrôlés à l'intérieur des zones photosensibles.

On propose selon l'invention de disposer entre les pixels adjacents un mur d'un matériau tendant à réfléchir la lumière de manière que la lumière arrivant de manière oblique sur un premier pixel ne tende pas à passer vers une zone photosensible correspondant à un pixel adjacent mais soit renvoyée par le mur vers la zone photosensible correspondant au premier pixel. Le mur est de préférence en matériau à forte réflexion tel que de l'aluminium, mais on peut envisager aussi qu'il soit en un matériau transparent mais dont l'indice de réfraction serait plus faible que celui des filtres afin de permettre une réflexion totale de la lumière arrivant sous une incidence oblique suffisamment faible. Selon l'invention, le mur s'étend en profondeur à l'intérieur de la couche semiconductrice monocristalline dans laquelle sont formées les zones photosensibles. En d'autres mots, le mur s'étend au-dessous de la surface de silicium correspondant aux zones photosensibles. On combine ainsi à la fois une amélioration de la diaphotie d'origine optique et de la diaphotie d'origine électronique, du fait que le mur empêche au moins en partie le passage de charges photogénérées d'un pixel vers un pixel adjacent.

Ainsi, l'invention propose un capteur d'image selon la revendication 1. Dans le cas d'un capteur d'images en couleur comportant un réseau de filtres colorés de couleurs différentes déposé au-dessus d'une couche semiconductrice comportant une zone photosensible associée à chaque filtre, chaque filtre coloré est séparé des filtres adjacents de couleur différente par le mur de matériau réfléchissant la lumière.

Le mur réduit la diaphotie à la fois photonique et électronique entre pixels adjacents, d'autant plus qu'il s'étend plus profond à l'intérieur de la couche. Un tel mur s'enfonçant dans le silicium n'aurait pas été envisageable en pratique avec des capteurs non amincis car il aurait perturbé les diffusions et la circuiterie électrique situées du côté de la face non amincie.

Le mur de séparation pénètre une zone semiconductrice (silicium en principe) de type P⁺ implantée ou diffusée dans la couche semiconductrice de type P contenant les zones photosensibles, la zone diffusée P⁺ formant elle-même une séparation électrique partielle entre zones photosensibles adjacentes.

La partie enfoncée du mur peut aussi, comme alternative, être entourée par une couche isolante.

La partie supérieure du mur réfléchissant est de préférence constituée par un revêtement d'un matériau antiréfléchissant. Ce matériau est de préférence du nitrure de titane.

Si le capteur est un capteur d'image en couleurs, il comporte des filtres de couleur associés chacun à une zone photosensible respective et séparés latéralement les uns des autres par le mur réfléchissant.

On notera que les publications de brevet US 2006/0081898 et US 2006/0145219 décrivent des surfaces réfléchissantes entre pixels pour ramener la lumière vers les photodiodes et améliorer la séparation entre elles.

Le Document JP2005150521 divulgue un capteur d'image sur un substrat semiconducteur aminci comprenant des murs réfléchissants de la lumière enfoncés dans le substrat.

D'autres caractéristiques et avantages de l'invention apparaîtront à la lecture de la description détaillée qui suit et qui est faite en référence aux dessins annexés dans lesquels :
- la figure 1 représente une coupe schématique d'un capteur d'image à substrat semiconducteur aminci ;
- la figure 2 représente une variante de réalisation dans laquelle les murs réfléchissants recouvrent une région de type P⁺ diffusée ;
- la figure 3 représente un capteur dans lequel les murs réfléchissants s'enfoncent partiellement dans le silicium ;
- les figures 4 et 5 représentent des variantes du capteur selon l'invention dans lesquelles la partie enfoncée du mur est entourée par une couche isolante ou par une diffusion de type P⁺.

L'invention sera décrite à propos d'un capteur d'images en couleurs, mais elle est applicable aussi à un capteur noir et blanc dépourvu de filtres de couleur sur la face amincie.

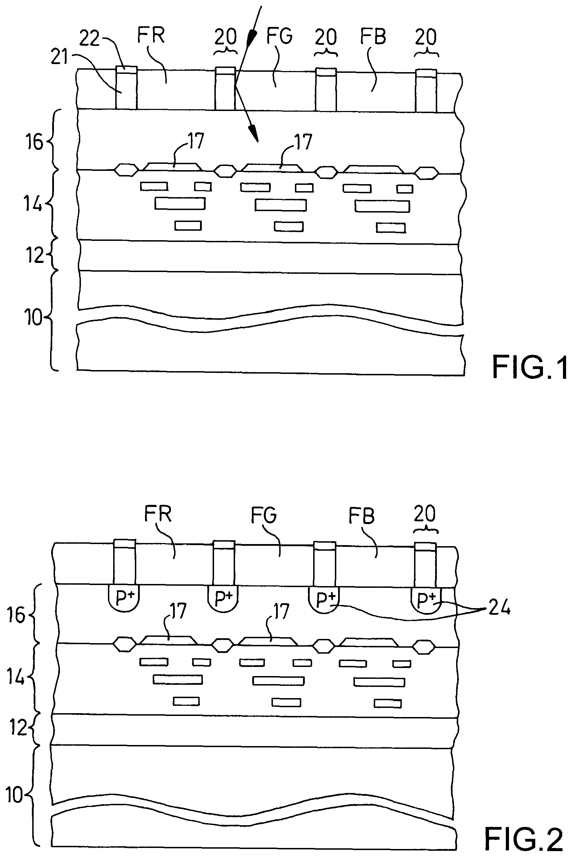

Sur la figure 1 on voit en coupe latérale la structure schématique d'un capteur d'image en couleurs de type aminci dont les pixels sont réalisés en technologie CMOS.

Le capteur comporte un substrat de support 10 recouvert d'une couche de planarisation 12 elle-même recouverte par un ensemble de couches conductrices et isolantes servant à collecter les charges électriques générées dans chaque pixel ; l'ensemble de couches conductrices et isolantes est représenté d'une manière schématique et est désigné par la référence 14 ; la structure et la configuration précise de ces couches dépend de la constitution électrique de chaque pixel ; par exemple on peut prévoir des pixels à trois ou quatre ou cinq transistors et on comprend que les couches conductrices servant à la formation de ces transistors ont des topologies qui sont adaptées en fonction de la constitution du pixel ; il peut y avoir par exemple quatre ou cinq niveaux conducteurs séparés par des couches isolantes, avec des vias conducteurs pour relier les niveaux les uns aux autres là où ils doivent être reliés.

L'ensemble 14 de couches conductrices et isolantes est recouvert par une couche semiconductrice 16, en principe en silicium, dans laquelle sont formées les zones photosensibles permettant la génération et la collection de charges électriques sous l'influence de la lumière. Typiquement, les zones photosensibles sont constituées par des photodiodes, une photodiode étant associée à chaque pixel ; les photodiodes sont constituées à partir d'une diffusion 17 de type N, dans le silicium de type P qui constitue la couche 16 ; c'est la diffusion de type N qui permet de recueillir les charges électriques photogénérées dans la couche 16 de type P et on peut considérer qu'une zone photosensible est constituée par une portion de couche 16 de type P située au-dessus d'une région diffusée 17 de type N. Les types de conductivité pourraient être tous inversés sans changer le principe de fonctionnement.

Au-dessus de la couche semiconductrice 16 sont déposés les filtres individuels colorés, en général sous forme d'une mosaïque de trois couleurs ; les filtres sont en principe regroupés en ensemble de quatre filtres adjacents dont deux filtres d'une même couleur (le plus souvent verte) sont diagonalement opposés tandis que les deux autres filtres diagonalement opposés correspondent à deux autres couleurs (en général bleu et rouge). Des dispositions en quinconce sont parfois utilisées. Les contours des filtres peuvent être carrés ou hexagonaux. Il y a un filtre coloré au-dessus de chaque zone photosensible élémentaire ou pixel.

Sur la figure on a représenté trois pixels adjacents correspondant aux trois couleurs verte, rouge, bleue ; les filtres sont désignés par FG (couleur verte), FR (couleur rouge), FB (couleur bleue).

La couche de silicium 16 est une couche amincie formée selon une technique connue rappelée plus haut : les diffusions 17 et l'empilement de couches isolantes et conductrices 14 servant à recueillir les charges photogénérées dans les zones photosensibles ont été formées par une face dite face avant d'un substrat semiconducteur (face tournée vers le bas sur la figure) ; puis on a reporté cette face avant sur le substrat de support 10 ; puis on a aminci le silicium du substrat semiconducteur par sa face arrière (face tournée vers le haut sur la figure) jusqu'à ne conserver que quelques micromètres d'épaisseur résiduelle (typiquement de 3 à 20 micromètres). L'éclairement des zones photosensibles se fait par la face arrière de la couche 16, donc par le haut sur la figure 1, c'est-à-dire par la face qui ne comporte pas l'empilement 14.

Les filtres adjacents de couleurs différentes sont séparés par un mur réfléchissant 20. Ce mur est de préférence constitué par un mur d'aluminium 21 recouvert d'une mince couche de nitrure de titane 22, cette dernière jouant le rôle de couche antiréfléchissante pour éviter que la lumière incidente issue d'une source d'image ne soit renvoyée vers cette source.

La lumière arrivant sous incidence normale au-dessus d'un filtre passe à travers ce filtre et atteint la zone photosensible correspondant au filtre. La lumière arrivant sur les bords d'un filtre sous incidence oblique est renvoyée vers la zone photosensible qui correspond au filtre au lieu de passer vers la zone photosensible correspondant au filtre adjacent.

Pour réaliser la mise en place des filtres entourés d'un mur d'aluminium, sur un capteur d'image aminci, on peut procéder de la manière suivante :
- on dépose une couche uniforme d'aluminium sur la face arrière du capteur, c'est-à-dire sur la face accessible de la couche de silicium 16 qui comprend les zones photosensibles ;
- on dépose une couche de nitrure de titane au-dessus de la couche d'aluminium ;
- on dépose une couche de résine photosensible que l'on grave selon un motif correspondant aux murs à réaliser en laissant subsister la résine au-dessus des emplacements des murs ;
- on attaque le nitrure de titane là où il n'est pas protégé par la résine, avec un produit d'attaque qui élimine le nitrure de titane sans attaquer significativement la résine ; puis, de la même manière, on élimine l'aluminium avec un produit d'attaque qui élimine l'aluminium sans attaquer la résine ;
- on élimine la résine ;
- on dépose une couche d'une résine colorée d'une première couleur et on la grave par une méthode photolithographique pour la laisser subsister uniquement à l'intérieur des emplacements entourés de murs d'aluminium et réservés aux filtres de la couleur considérée ;
- on dépose une couche d'une résine colorée d'une deuxième couleur et on la grave par une méthode photolithographique pour la laisser subsister uniquement à l'intérieur des emplacements entourés de murs d'aluminium et réservés aux filtres de la deuxième couleur ;
- on dépose une couche d'une résine colorée d'une troisième couleur et on la grave par photolithographie pour la laisser subsister uniquement à l'intérieur des emplacements entourés de murs d'aluminium et réservés aux filtres de la troisième couleur.

Ces étapes de dépôt et gravure de filtres en couleur sont classiques pour tous les capteurs d'image en couleur, mais ici les filtres colorés sont déposés à l'intérieur d'espaces entourés de murs d'aluminium. Si le capteur n'est pas un capteur couleur, les étapes de dépôt et gravure de filtres ne sont pas prévues.

On peut, en variante, former les murs d'aluminium de la manière suivante : on dépose une couche sacrificielle, par exemple en oxyde de silicium, que l'on ouvre à l'endroit où on veut réaliser les murs réfléchissants, on dépose l'aluminium qui comble les ouvertures réalisées, on rabote l'excédent d'aluminium présent en dehors des ouvertures, et on enlève la couche sacrificielle à l'aide d'un produit d'attaque qui élimine cette couche en n'attaquant pas l'aluminium, laissant donc intacts les murs d'aluminium. Du nitrure de titane (couche anti-reflet) peut être déposé et gravé avant l'enlèvement de la couche sacrificielle, dans ce cas, le produit d'attaque de la couche sacrificielle ne doit pas attaquer le nitrure de titane.

Pour améliorer la diaphotie électronique, c'est-à-dire pour limiter les risques de dispersion des électrons vers des zones photosensibles adjacentes à celle où ils ont été engendrés par la lumière, on peut de plus, comme le montre la figure 2, prévoir un dopage de type P⁺ qui s'enfonce dans la couche semiconductrice 16 de type P, au-dessous des murs réfléchissants. Ce dopage crée des régions 24 qui séparent au moins partiellement les unes des autres les zones photosensibles adjacentes définies dans la couche semiconductrice 16 ; les régions P⁺ créent en effet un champ électrique répulsif pour les électrons, tendant à maintenir ceux-ci dans la zone photosensible où ils ont été engendrés, jusqu'à ce qu'ils soient collectés par la zone de charge d'espace constituée dans le substrat et la région diffusée 17 autour de la jonction de la photodiode associée à cette zone photosensible. Les régions 24 sont formées avant le dépôt de la couche d'aluminium qui sert à former les murs réfléchissants. Elles peuvent en particulier être formées après l'ouverture de la couche sacrificielle mentionnée plus haut, avec l'avantage d'un parfait alignement.

Les régions P+ 24 sont implantées dans la face accessible de la couche semiconductrice après report de la face opposée (celle qui porte l'empilement de couches conductrices et isolantes 14) sur le substrat de support 10. Les murs réfléchissants 20 sont formés après réalisation des régions dopées 24.

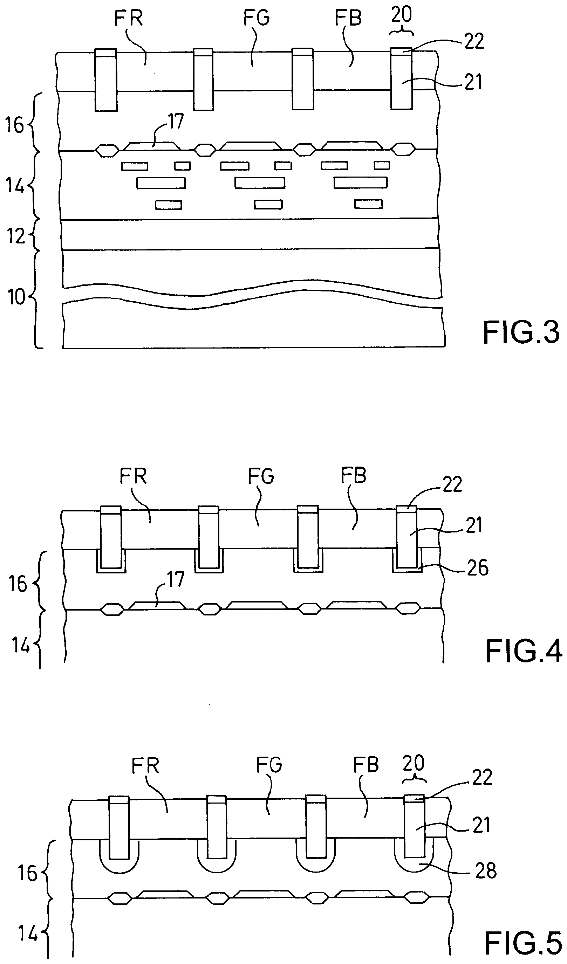

Dans l'invention représentée à la figure 3, on prévoit que les murs réfléchissants 20 s'enfoncent en partie dans la couche semiconductrice 16. Cet enfoncement améliore la diaphotie optique et contribue aussi à séparer électriquement les zones photosensibles adjacentes : il contribue donc à réduire la diaphotie électronique entre pixels adjacents. Pour réaliser la structure dans ce cas, on creuse des ouvertures dans la couche 16 de silicium avant de déposer la couche d'aluminium. Le masque de gravure pour creuser ces ouvertures est le même que le masque de gravure de la couche sacrificielle qui définit la position des murs.

Dans une variante, dérivée de la figure 3 et représentée à la figure 4, on isole du silicium la partie enfoncée des murs réfléchissants, afin que les murs d'aluminium ne soient pas directement en contact électrique avec le silicium; cette isolation est faite par exemple par une couche d'oxyde de silicium 26. La partie enfoncée et isolée des murs réfléchissants crée une séparation entre zones photosensibles adjacentes, améliorant la diaphotie électrique.

Dans la variante représentée à la figure 5, on prévoit que la partie enfoncée des murs réfléchissants est entourée par une région dopée 28 de type P⁺ jouant le même rôle de séparation entre zones photosensibles adjacentes que la région 24 de la figure 2. L'opération de dopage du silicium par implantation ou par diffision, qui sert à constituer les régions 28, peut être faite avant ou après la gravure d'ouvertures dans le silicium de la couche 16 (ouvertures destinées à recevoir la partie enfoncée des murs d'aluminium 20).

La région dopée P+ 28, de même que la couche isolante 26 de la figure 4, permettent aussi d'éviter que l'aluminium entre en contact directement avec la couche P moins dopée qui sert à générer les charges photosensibles. En effet, les défauts qui seraient créés à l'interface aluminium-silicium généreraient des courants d'obscurité gênants. La région p+ permet une recombinaison immédiate des porteurs générés par ces défauts.

Il faut remarquer qu'une structure de capteur d'image plus classique à silicium non aminci ne permettrait normalement pas de faire de tels murs réfléchissants enfoncés dans la profondeur de la couche de silicium, car l'enfoncement des murs perturberait de manière importante la structure s'il était réalisé du côté où ont été faites les diffusions 17 et les empilements de couches conductrices et isolantes 14 servant à constituer les pixels.

Enfin, dans les pixels à transistors MOS actifs qui comportent en général une zone de stockage de charges associée à la photodiode, il peut être souhaitable d'éviter autant que possible que cette zone de stockage reçoive un éclairement direct. C'est pourquoi on propose avantageusement que les murs réfléchissants aient un périmètre qui entoure non pas la totalité du pixel mais plus précisément le contour de la zone photosensible proprement dite, en recouvrant entièrement le reste des éléments du pixel (transistors et zone de stockage de charges). La couche d'aluminium ou d'un autre matériau réfléchissant occupe ainsi tout l'espace ou pratiquement tout l'espace existant entre les photodiodes des pixels adjacents, les filtres colorés recouvrant alors uniquement les photodiodes définies par les régions diffusées 17.

## Revendications

1. Capteur d'image à couche semiconductrice amincie (16) éclairée par la face arrière, ladite face arrière étant la face opposée à la face dans laquelle ont été formées un réseau de zones photosensibles et une circuiterie permettant de recueillir les charges photogénérées par lesdites zones photosensibles, ladite face arrière comportant, autour de chaque zone photosensible, un mur (20) de matériau réfléchissant la lumière, le mur s'étendant en profondeur depuis la surface de la face arrière de la couche semiconductrice amincie de façon que le mur comprend une partie enfoncée dans ladite couche semiconductrice amincie, ladite partie enfoncée du mur étant entourée soit par une couche isolante (26), soit par une région de type P+ (28) formée dans ladite couche semiconductrice amincie quand ladite couche semiconductrice amincie est du type P.

2. Capteur d'image selon la revendication 1, **caractérisé en ce que** le mur (20) est fait à partir d'aluminium.

3. Capteur d'image selon la revendication 1, **caractérisé en ce que** la partie supérieure, non enfoncée, du mur (20) est formée par une couche superficielle d'un matériau anti-reflet (22), notamment du nitrure de titane.

4. Capteur d'image selon l'une des revendications précédentes, à pixels CMOS actifs, comprenant en plus d'une photodiode, des transistors et une zone de stockage de charges associée à la photodiode, **caractérisé en ce que** les murs réfléchissants ont un périmètre qui entoure non pas la totalité du pixel actif mais plus précisément le contour de la photodiode, en recouvrant entièrement le reste des éléments du pixel actif.

5. Capteur d'image en couleurs selon l'une des revendications 1 à 4, **caractérisé en ce qu'**il comporte des filtres de couleur (FR, FG, FB) pourvus sur la face arrière de la couche semiconductrice amincie (16) et associés chacun à une zone photosensible respective et séparés latéralement les uns des autres par le mur réfléchissant.

## Patentansprüche

1. Bildsensor mit verschmälerter Halbleiterschicht (16), welche von der Rückseite beleuchtet wird, wobei die Rückseite die Seite ist, welche derjenigen Seite gegenüber liegt, in welcher ein Netz von lichtempfindlichen Bereichen und eine Schaltung gebildet worden sind, welche es ermöglichen, die durch die lichtempfindlichen Bereiche lichterzeugten Ladungen zu sammeln, wobei die Rückseite um jeden lichtempfindlichen Bereich herum eine Mauer (20) aus lichtreflektierendem Material beinhaltet, wobei die Mauer sich in der Tiefe von der Oberfläche der Rückseite der verschmälerten Halbleiterschicht in einer Weise erstreckt, dass die Mauer einen in die verschmälerte Halbleiterschicht eingesunkenen Teil beinhaltet, wobei der eingesunkene Teil der Mauer entweder durch eine isolierende Schicht (26) oder durch einen Bereich vom Typ P+ (28) umgeben ist, welcher in der verschmälerten Halbleiterschicht gebildet ist, wenn es sich um eine verschmälerte Halbleiterschicht vom Typ P handelt.

2. Bildsensor nach Anspruch 1, **dadurch gekennzeichnet, dass** die Mauer (20) anhand von Aluminium gebildet ist.

3. Bildsensor nach Anspruch 1, **dadurch gekennzeichnet, dass** der obere, nicht eingesunkene Teil der Mauer (20) aus einer oberflächlichen Schicht eines entspiegelten Materials (22) gebildet ist, insbesondere aus Titannitrid.

4. Bildsensor nach einem der vorhergehenden Ansprüche, mit aktiven CMOS-Pixeln, welcher zusätzlich zu einer Photodiode Transistoren und einen Speicherbereich von Ladungen besitzt, welcher mit der Photodiode verbunden ist, **dadurch gekennzeichnet, dass** die reflektierenden Mauern einen Umfang besitzen, welcher nicht die Gesamtheit des aktiven Pixels, sondern genauer gesagt die Kontur der Photodiode umgibt, indem er den Rest der Bauteile des aktiven Pixels vollständig überlappt.

5. Farbbildsensor nach einem der Ansprüche 1 bis 4, **dadurch gekennzeichnet, dass** er Farbfilter (FR, FG, FB) beinhaltet, welche auf der Rückseite der verschmälerten Halbleiterschicht (16) bereitgestellt und jeweils mit einem jeweiligen lichtempfindlichen Bereich verbunden und seitlich voneinander durch die reflektierende Mauer getrennt sind.

## Claims

1. An image sensor with thinned semiconductor layer (16) lit via the rear face, said rear face being the opposite face to the face in which a network of photosensitive zones and a circuitry for collecting the charges photogenerated by said photosensitive zones has been formed, said rear face comprising, around each photosensitive zone, a wall (20) of material reflecting the light, the wall extending depthwise from the surface of the rear face of the thinned semiconductor layer in a such a way that the wall comprises a part sunk into said thinned semiconductor layer, said sunk-in part of the wall being surrounded either by an insulating layer (26) or a P+-type zone (28) formed in said thinned semiconductor layer when said thinned semiconductor layer is of P-type.

2. The image sensor as claimed in claim 1, **characterized in that** the wall (20) is made from aluminum.

3. The image sensor as claimed in claim 1, **characterized in that** the not sunk-in top part of the wall (20) is formed by a surface layer of an antireflection material (22), notably titanium nitride.

4. The image sensor as claimed in one of the preceding claims, with active CMOS pixels, comprising in addition to a photodiode, transistors and a charge storage zone associated with the photodiode, **characterized in that** the reflecting walls have a perimeter that surrounds not all of the active pixel but more specifically the outline of the photodiode, by entirely covering the rest of the elements of the active pixel.

5. The color image sensor as claimed in one of claims 1 to 4, **characterized in that** it comprises color filters (FR, FG, FB) provided on the rear face of the thinned semiconductor layer (16) and each associated with a respective photosensitive zone and laterally separated from each other by the reflecting wall.
